# EUROPEAN PATENT APPLICATION

(11) **EP 3 820 254 A1**
(43) Date of publication of application: **12.05.2021**
(21) Application number: 19207972.1
(22) Date of filing: 08.11.2019
(51) Int. Cl.: H05B 45/39

(54) **IMPROVED TIME MEASUREMENT ACCURACY FOR DC SUPPLY**

(71) Applicant: Tridonic GmbH & Co. KG, 6851 Dornbirn (AT)
(72) Inventor: Moosbrugger, Lukas, 6850 Dornbirn (AT)
(74) Representative: Beder, Jens

(57) **Abstract**

The present invention provides an operating device (1) for operating one or more lighting means (8), the operating device (1) comprising: an power input (IN, IN') electrically connectable to an external AC voltage source (7), preferably mains, an power output (OUT, OUT') to which the one or more lighting means are electrically connectable, a supply circuitry (2) configured to supply via the power output (OUT, OUT') the one or more lighting means (8) with DC power from an AC voltage provided by the external AC voltage source (7) via the power input (IN, IN') to the supply circuitry (2), and a control circuitry (3) comprising a processing unit (3a) configured to control the supply circuitry (2) and an internal timer (3b) configured to provide to the processing unit (3a) a first clock signal; wherein the processing unit (3a) is configured to calibrate the internal timer (3b) on the basis of the temporal course of the AC voltage. In addition a luminaire comprising the operating device according to the present invention and a calibration method are provided.

## Description

The present invention relates to an operating device for operating one or more lighting means, to a luminaire comprising such an operating device and one or more lighting means as well as to a calibration method.

In the prior art, operating devices for operating lighting means, such as light emitting diodes (LEDs), which provide the lighting means with electric DC power are well known. In such operating devices, internal measurement of time intervals is essential for many control processes.

For this, usually the control circuitry of an operating device is connected with an external crystal timer comprising a crystal oscillator for providing a clock signal to the control circuitry. A crystal timer including a crystal oscillator may also be referred to as *"quartz timer including a quartz oscillator".* Crystal timers have the advantage of a high accuracy, but they are disadvantageous with regard to the space needed and costs.

Instead of using an external crystal timer the control circuitry may use the clock signal provided by an internal timer already present in the control circuitry for time measurement. For example, when the control circuitry is a microprocessor or microcontroller the clock signal provided by the internal timer of the microprocessor or microcontroller may be used for the measurement of time.

This use of an internal timer already present in the control circuitry has the disadvantage of a lower accuracy compared to the accuracy provided by an external crystal timer.

Therefore, it is an object of the present invention to provide an operating device in which a detection/measurement of time is possible without the above described disadvantages.

This and other objects, which become apparent upon reading the following description, are solved by the subject-matter of the independent claims. The dependent claims refer to preferred embodiments of the invention.

### Summary of the invention

According to the present invention an operating device for operating one or more lighting means is provided, wherein the operating device comprises
- a power input electrically connectable to an external AC voltage source, preferably mains,
- a power output to which the one or more lighting means are electrically connectable,
- a supply circuitry configured to supply via the power output the one or more lighting means with DC power from an AC voltage provided by the external AC voltage source via the power input to the supply circuitry, and
- a control circuitry comprising a processing unit configured to control the supply circuitry and an internal timer configured to provide to the processing unit a first clock signal; wherein the processing unit is configured to calibrate the internal timer on the basis of the temporal course of the AC voltage.

In other words, the present invention proposes to use the clock signal provided by an internal timer already present in the control circuitry for a measurement of time, wherein the accuracy of the internal timer with regard to a measurement of time is assured by a calibration of the internal timer on the basis of the temporal course of the AC voltage. In particular, for this the AC mains voltage from mains is used, when present at the power input of the operating device, because the frequency and, thus, period of the AC mains voltage is well known and very stable.

That is, according to the present invention an AC voltage with a known and stable frequency present at the power input of the operating device for providing DC power to the one or more lighting means is used for calibrating the internal timer.

Therefore, the operating device of the present invention has the advantage of a high accuracy for measuring time without needing an external crystal timer, saving space and reducing costs.

In the context of the present invention, the term *"internal timer"* has to be understood as a timer that is a part of the control circuitry, in particular arranged inside the casing of the control circuitry. That is, the term *"internal timer"* does not refer to a timer that is arranged external to the control circuitry and externally connected with the control circuitry.

The supply circuitry in particular comprises at least one converter stage that can be controlled by the control circuitry, in particular by the processing unit, to supply DC power to the one or more lighting means from the AC voltage, in the form of a voltage or current.

Preferably, the at least one converter stage is an actively switched converter stage with at least one switch and at least one inductor, wherein the control circuitry, in particular the processing unit, is configured to control the switching of the at least one switch in order to control the amount of DC power provided to the one or more lighting means and, thus, to control the amount of light emitted by the one or more lighting means. Examples of such an actively switched converter stage comprise a boost converter, buck converter, flyback converter etc.

Preferably, the supply circuitry comprises at least one current source controllable by the control circuitry, in particular by the processing unit, wherein the at least one current source is configured to provide from the AC voltage a DC current to the one or more lighting means. In such a case, the one or more lighting means are preferably one or more light emitting diodes.

The one or more lighting means are preferably one or more light emitting diodes (LEDs), such as organic light emitting diodes, inorganic light emitting diodes etc. The one or more lighting means may also be a different type of lighting means. In particular, the one or more lighting means may be installed in outdoor lighting such as street lighting.

Preferably, the control circuitry, in particular the processing unit, is configured to control the supply circuitry on the basis of physical parameters, such as the current provided via the power output of the operating device to the one or more lighting means, light emitted by the one or more lighting means etc. Further, the control circuitry, in particular the processing unit, is preferably configured to perform a feedback control of the supply circuitry.

In particular, the processing unit is configured to detect, respectively measure, time on the basis of the first clock signal.

Preferably, the operating device comprises a detection unit configured to detect zero-crossings of the AC voltage and to provide the detected zero-crossings to the processing unit, and the processing unit is configured to calibrate the internal timer on the basis of the detected zero-crossings of the AC voltage and the frequency of the AC voltage.

Since the period of the AC voltage is the inverse of the frequency of the AC voltage, according to the present invention whenever the frequency of a voltage such as the AC voltage is used, the corresponding period of the voltage may also be used. Thus, the processing unit is preferably configured to calibrate the internal timer on the basis of the detected zero-crossings of the AC voltage and the period of the AC voltage.

The detection unit preferably comprises a voltage divider and/or an auxiliary winding for detecting the zero-crossings of the AC voltage. The detection unit may alternatively or in addition comprise other means known to the skilled person for detecting the AC voltage, in particular the zero-crossings of the AC voltage.

Preferably the operating device, in particular the control circuitry, comprises a zero-crossing timer configured to provide a second clock signal to the processing unit by detecting the zero-crossings of the AC voltage, and the processing unit is configured to calibrate the internal timer on the basis of the second clock signal.

Since the zero-crossing timer provides the second clock signal on the basis of the AC voltage, it has a high accuracy without having the disadvantages of an external crystal oscillator. Namely, as already mentioned above, the frequency and the period of the AC mains voltage from mains is well known and very stable.

In particular, the zero-crossing timer provides the second clock signal on the basis of the zero-crossings of the AC voltage and the frequency of the AC voltage.

Further, the internal timer preferably comprises an internal oscillator providing an oscillating signal as the first clock signal, wherein a number of oscillations of the oscillating signal is assigned to a first time interval.

That is, a number of oscillations of the first clock signal (oscillating signal) is assigned to a first time interval, such that the processing unit may detect time intervals on the basis of the first clock signal, in particular on the basis of the number of oscillations of the first clock signal.

In particular, the processing unit is configured to detect respectively measure time on the basis of the oscillations of the first clock signal using the assignment between a number of oscillations and a first time interval.

In particular, the processing unit assigns a number of oscillations of the first clock signal (oscillating signal) to a first time interval on the basis of the frequency respectively period of the first clock signal.

Preferably, the assignment of a number of oscillations of the first clock signal (oscillating signal) to a first time interval may be calculated by the processing unit using a corresponding algorithm, in particular equation, and/or may be saved in a data storage of the operating device, for example, in a lookup table, and received by the processing unit from the data storage. Such a data storage may be part of the control circuitry.

Preferably, the internal oscillator corresponds to a RC oscillator.

Furthermore, the processing unit is preferably configured to calibrate the internal timer by comparing the temporal course of the AC voltage with the temporal course of the oscillations of the first clock signal during a calibration time interval.

Preferably, the calibration time interval is a time value stored in the operating device, in particular in the control circuitry, or a time value received from extern of the operating device that is used for the calibration of the internal timer.

Moreover, the processing unit is preferably configured to determine the number of zero-crossings of the AC voltage corresponding to the calibration time interval, and determine the number of oscillations of the first clock signal corresponding to the determined number of zero-crossings of the AC voltage.

In particular, the processing unit is configured to determine the number of zero-crossings of the AC voltage corresponding to the calibration time interval on the basis of the zero-crossings detected by the detection unit and the frequency of the AC voltage.

The processing unit is preferably configured to determine the number of oscillations of the first clock signal corresponding to the determined number of zero-crossings of the AC voltage by detecting the oscillations of the first clock signal.

Further, the processing unit is preferably configured to determine the first time interval assigned to the determined number of oscillations of the first clock signal, compare the determined first time interval with the calibration time interval, and assign the calibration time interval as the first time interval to the determined number of oscillations of the first clock signal, in case the determined first time interval does not equal to the calibration time interval.

In particular, the processing unit is configured to determine the first time interval assigned to the determined number of oscillations of the first clock signal by calculation using a corresponding algorithm, in particular equation, and/or by receiving the first time interval from a data storage of the operating device, for example, from a lookup table of the data storage, in which the assignment is saved.

The processing unit is preferably configured to assign the calibration time interval to the determined number of oscillations of the first clock signal by adapting the algorithm, in particular equation, and/or by storing this assignment in the data storage of the operating device, for example in the lookup table of the data storage.

Preferably, the operating device comprises a data storage (such as the one mentioned above), wherein the processing unit is configured to save the assignment between the calibration time interval and the determined number of oscillations of the first clock signal in the data storage.

The processing unit is preferably configured to receive this assignment from the data storage and measure time on the basis of the first clock signal using this assignment.

In particular, the processing unit is configured to save data (write data) in the data storage and to receive data (read data) from the data storage.

Preferably, the processing unit is configured to save the assignment between the calibration time interval and the determined number of oscillations of the first clock signal in a lookup table of the data storage.

The data storage is preferably an internal data storage of the control circuitry. That is, the data storage is preferably a part of the control circuitry.

Further, the operating device preferably comprises a temperature sensor, and the processing unit is configured to carry out the calibration of the internal timer for different temperatures.

The accuracy of the internal timer is stable over the time and may only be influenced by the temperature, because the period and, thus, frequency of the oscillating signal (first clock signal) provided by the internal oscillator is dependent on temperature. Therefore, once the internal timer has been calibrated for a temperature, the operating device operating one or more lighting means at this temperature may detect time on the basis of the first clock signal of the internal timer with a high accuracy.

According to the present invention, the temperature sensor is not limited to a specific type of temperature sensor. The temperature sensor is configured to measure the temperature of the operating device, in particular of the internal timer. In particular, the temperature sensor is configured to measure the temperature in a vicinity and/or inside the operating device. Moreover, in particular, the temperature sensor is configured to measure the temperature in a vicinity and/or inside the control circuitry. In addition or alternatively, the temperature sensor is configured to measure the temperature in a vicinity and/or inside the internal timer.

Furthermore, the processing unit is preferably configured to assign the calibration time interval to the determined number of oscillations of the first clock signal individually for different temperatures, and save these assignments for different temperatures in the data storage.

That is, in the data storage for each temperature the assignment of the calibration time interval to the determined number of oscillations of the first clock signal may be saved.

The processing unit is preferably configured to detect time on the basis of the first clock signal using the assignment of the calibration time interval to the determined number of oscillations of the first clock signal (calibrated assignment), the assignment corresponding to the actual temperature of the operating device, in particular of the internal timer. The temperature sensor preferably provides the processing unit with corresponding temperature data of the operating device.

In particular, the processing unit is configured to assign the calibration time interval to the determined number of oscillations of the first clock signal for different temperatures, and save these assignments for different temperatures in a lookup table of the data storage

Moreover, the operating device preferably comprises an AC voltage detection unit configured to detect the AC voltage at the power input, and the processing unit is configured to calibrate the internal timer in case that the AC voltage is present at the power input.

The AC voltage detection unit may be the detecting unit configured to detect zero-crossings of the AC voltage.

Preferably, the AC voltage detection unit comprises a voltage divider and/or an auxiliary winding for detecting the AC voltage. The AC voltage detection unit may alternatively or in addition comprise other means known to the skilled person for detecting the AC voltage.

Preferably, the processing unit is configured to repeatedly calibrate the internal timer in a time interval. In particular, the processing unit is configured to periodically calibrate the internal timer.

In addition or alternatively, the processing unit is preferably configured to calibrate the internal timer, in case the processing unit determines a temperature change on the basis of temperature data provided by the temperature sensor.

In addition or alternatively, the processing unit is preferably configured to calibrate the internal timer at the time of turning on the operating device.

Further, the control circuitry is preferably a microprocessor or microcontroller internally comprising the internal timer.

Preferably, the control circuitry is an integrated circuit and the internal timer is part of this integrated circuit.

Preferably, the operating device is an emergency lighting operating device comprising a energy storage, such as a battery, wherein the control circuitry is electrically supplied with DC power from the energy storage, and the supply circuitry is configured to supply via the power output the one or more lighting means with DC power from the energy storage.

That is, preferably the supply circuitry is configured to supply via the power output the one or more lighting means with DC power from the AC voltage, in case the AC voltage is present at the power input of the operating device, and to supply via the power output the one or more lighting means with DC power from the electrical energy stored in the energy storage, in case the AC voltage is not present at the power input or in case that the level of AC voltage present at the power input is below a threshold voltage. The energy storage may be part of the supply circuitry.

In particular, the energy storage is a rechargeable energy storage, such as a rechargeable battery. Preferably, the operating device comprises a charging unit configured to charge the rechargeable energy storage from the AC voltage, in case the AC voltage is present at the power input of the operating device. The charging unit may be part of the supply circuitry.

Preferably, the supply circuitry is configured to supply via the power output the one or more lighting means with DC power always from the energy storage, wherein the energy storage is charged, in case the AC voltage is present at the power input of the operating device. The supply circuitry is preferably configured to supply via the power output the one or more lighting means with DC power from the AC voltage used to charge the energy storage, in case the AC voltage is present at the power input of the operating device.

In order to achieve the operating device according to the present invention, some or all of the above described optional features may be combined with each other.

According to the present invention a luminaire is provided, wherein the luminaire comprises an operating device according to the present invention, as described above, and one or more lighting means electrically connected to the power output of the operating device; wherein the operating device is configured to operate the one or more lighting means by supplying the one or more lighting means with DC power.

The above description with regard to the operating device according to the present invention is also valid for the operating device of the luminaire.

The one or more lighting means are preferably one or more light emitting diodes, such as organic light emitting diodes, inorganic light emitting diodes etc. The one or more lighting means may also be a different type of lighting means. In particular, the one or more lighting means may be installed in outdoor lighting such as street lighting.

In particular, the luminaire is an outdoor luminaire, such as a street light.

According to the present invention a method of calibrating the internal timer of the control circuitry of an operating device according to the present invention, as described above, is provided, wherein the method comprises the step of calibrating by the processing unit the internal timer on the basis of the temporal course of the AC voltage.

The above description with regard to the operating device according to the present invention is correspondingly valid for the calibration method according to the present invention.

In the following, the invention is described exemplarily with reference to the enclosed figures, in which
**Figure 1** is a schematic view of an operating device according to a preferred embodiment of the invention;
**Figure 2** is a flow chart of a calibration method according to a preferred embodiment of the invention that may be carried out by an operating device according to the invention; and
**Figure 3** is a graph exemplarily showing a calibration method according to a preferred embodiment of the invention performed by the operating device according to Figure 1.

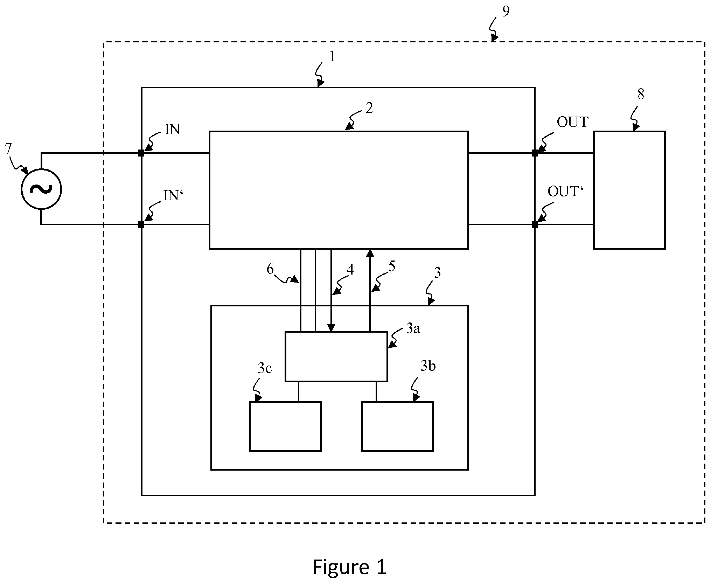

**Figure 1** is a schematic view of an operating device according to a preferred embodiment of the invention. According to Figure 1, the operating device 1 comprises a power input with input terminals IN, IN', a power output with output terminals OUT, OUT', a supply circuitry 2 electrically connected between the power input and power output and a control circuitry 3 configured to control the supply circuitry 2.

The control circuitry 3 comprises a processing unit 3a, an internal timer 3b and a data storage 3c.

As shown in Figure 1, one or more lighting means 8 may be electrically connected to the power output, in particular the output terminals OUT, OUT', of the operating device 1. The power input, in particular the input terminals IN, IN' may be electrically connected to an external AC voltage source 7 providing an AC voltage via the power input to the operating device 1. In particular, the external AC voltage source 7 is mains providing AC mains voltage via the power input to the operating device 1.

The one or more lighting means 8 are preferably one or more light emitting diodes, such as organic light emitting diodes, inorganic light emitting diodes etc. The one or more lighting means 8 may also be a different type of lighting means. In particular, the one or more lighting means 8 may be installed in outdoor lighting such as street lighting.

As shown in Figure 1, the operating device 1 and the one or more lighting means 8 form a luminaire 9.

In particular, the luminaire 9 is an outdoor luminaire, such as a street light.

The supply circuitry 2 is configured to supply via the power output, in particular the output terminals OUT, OUT', the one or more lighting means 8 with DC power. The above description of the supply circuitry of the operating device according to the present invention is also valid for the supply circuitry 2 of Figure 1.

In particular, the supply circuitry 2 is configured to supply the one or more lighting means 8 with DC power from the AC voltage provided by the external AC voltage source 7 (mains), in case the AC voltage is available at the power input respectively input terminals IN, IN' of the operating device 1. The supply circuitry 2 is also configured to supply the control circuitry 3, in particular the processing unit 3a, with electrical power. This is indicated in Figure 1 by the two supply lines 6.

Optionally, the operating device 1 comprises an energy storage such as a battery (not shown in Figure 1), wherein the control circuitry 3 is electrically supplied with DC power from the energy storage. Furthermore, the supply circuitry 2 is then configured to provide via the power output the one or more lighting means 8 with DC power from electrical energy stored in the energy storage, at least in case that no AC voltage is available at the power input of the operating device 1 or in case that the level of AC voltage at the power input is below a threshold voltage. Such an operating device 1 is also called emergency lighting operating device configured to electrically supply the one or more lighting means 8 in case that normal AC voltage is not provided by the external AC voltage source 7 (mains) due to an emergency event such as mains failure.

The energy storage may be a rechargeable energy storage, such as a rechargeable battery, and the operating device 1 may comprise a charging unit (not shown in Figure 1) for charging the rechargeable energy storage from the AC voltage, in case the AC voltage is provided by the external AC voltage source 7 (mains) to the power input of the operating device 1.

The energy storage and the charging unit may be part of the supply circuitry 2.

The control circuitry 3, in particular the processing unit 3a, is configured to control the supply circuitry 2 and, thus, control the DC power supplied by the supply circuitry 2 via the power output to the one or more lighting means 8. The control circuitry 3, in particular the processing unit 3a, is configured to provide control signals 5 to the supply circuitry 2 in order to control the DC power supply by the supply circuitry 2 to the one or more lighting means 8. The above description of the control circuitry of the operating device according to the present invention is also valid for the control circuitry 3 of Figure 1.

As shown in Figure 1 the internal timer 3b is a part of the control circuitry 3.

The control circuitry 3 may be a microprocessor or microcontroller internally comprising the internal timer 3b. That is, the control circuitry 3 may be a microprocessor or microcontroller, wherein the internal timer 3b is part of the microprocessor or microcontroller. In particular, the internal timer 3b is arranged inside the casing of the control circuitry 3.

The internal timer 3b comprises an internal oscillator (not shown in Figure 1) providing an oscillating signal as a first clock signal to the processor unit 3a, wherein a number of oscillations of the oscillating signal is assigned to a first time interval. The internal oscillator may be a RC oscillator.

The processing unit 3a is configured to determine time intervals (measure time) on the basis of the first clock signal provided by the internal oscillator of the internal timer 3b. In order to assure a high accuracy of this first clock signal, the processing unit 3a is configured to calibrate the internal timer 3b on the basis of the temporal course of the AC voltage (mains voltage) provided by the external AC voltage source 7 (mains) via the power input to the operating device 1.

The data storage 3c is configured to save the assignment between a number of oscillations of the first clock signal and a first time interval, in particular in a lookup table. The processing unit 3a is configured to measure time on the basis of the first clock signal using this assignment saved in the data storage 3c. According to Figure 1 the data storage 3c is part of the control circuitry 3. The data storage 3c may also be arranged outside the control circuitry 3.

In particular, the processing unit 3a is configured to save data (write data) in the data storage 3c and to receive data (read data) from the data storage 3c.

The control circuitry 3 may provide more functions than described above or shown in Figure 1, such as a communication functionality for communication with outside, for example via a DALI bus. The present description however is directed to the description of time interval determination respectively time measurement by the control circuitry 3 and the calibration of the internal timer 3b. Thus, those further functionalities are neither described herein nor shown in the Figures.

The processing unit 3a may receive from the supply circuitry 2 detection signals 4 of the AC voltage, in particular zero-crossings of the AC voltage. In particular, the operating device 1 may comprise a detection unit (not shown in Figure 1) configured to detect zero-crossings of the AC voltage and to provide the detected zero-crossings to the processing unit 3a. Moreover, the operating device 1 may comprise an AC voltage detection unit (not shown in Figure 1) configured to detect the presence or absence of the AC voltage at the power input of the operating device 1. As outlined already above, the detection unit configured to detect zero-crossings and the AC voltage detection unit may be the same unit.

The processing unit 3a is configured to calibrate the internal timer 3b on the basis of the detected zero-crossings of the AC voltage and the frequency of the AC voltage. In particular, the processing unit 3a is configured to calibrate the internal timer 3b by comparing the temporal course of the AC voltage with the temporal course of the oscillations of the first clock signal during a calibration time interval.

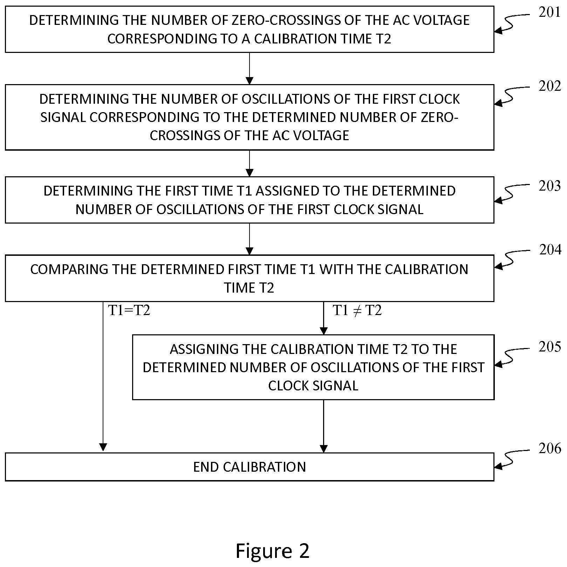

In the following, a calibration of the internal timer 3b by the processing unit 3a is described with reference to Figure 2.

In a first step 201, the processing unit 3a determines the number of zero-crossings of the AC voltage (mains) corresponding to a calibration time interval T2. In particular, the processing unit 3a determines the number of zero-crossings of the AC voltage corresponding to the calibration time interval T2 on the basis of the zero-crossings detected by a corresponding detection unit and the frequency respectively period of the AC voltage.

In step 202 following step 201, the processing unit 3a determines the number of oscillations of the first clock signal corresponding to the determined number of zero-crossings of the AC voltage. In particular, the processing unit 3a determines the number of oscillations of the first clock signal corresponding to the determined number of zero-crossings of the AC voltage by detecting the oscillations of the first clock signal.

In step 203 following the step 202, the processing unit 3a determines the first time interval T1 assigned to the determined number of oscillations of the first clock signal. In particular, the processing unit 3a is configured to determine the first time interval T1 assigned to the determined number of oscillations by a calculation using a corresponding algorithm, in particular equation, and/or by receiving the first time interval T1 from the data storage 3c, for example from a lookup table of the data storage 3c, in which the assignment is saved.

In step 204 following step 203, the processing unit 3a compares the determined first time interval T1 with the calibration time interval T2. In case the determined first time interval T1 equals to the calibration time interval T2 the method continues to step 206 and in case the determined first time interval T1 does not equal to the calibration time interval T2 the method continues to step 205.

In step 205, the processing unit 3a assigns the calibration time interval T2 as the first time interval to the determined number of oscillations of the first clock signal. In particular, the processing unit is configured to assign the calibration time interval T2 to the determined number of oscillations of the first clock signal by adapting the algorithm, in particular equation, and/or by saving this assignment in the data storage 3c, for example, in the look up table of the data storage 3c.

In the step 206, the processing unit 3a stops the calibration method.

The assignment of the first time interval T1 to the determined number of oscillations of the first clock signal in step 203 corresponds to an original assignment. The assignment of the calibration time interval T2 assigned as the first time interval to the determined number of oscillations of the first clock signal in step 205 corresponds to a calibrated assignment, because in step 204 it was found out that the original assignment is not accurate respectively is erroneous. The processing unit 3a is configured to detect time intervals (measures time) on the basis of the first clock signal using such a calibrated assignment.

The processing unit 3a calibrates the internal timer 3b in case that the AC voltage (mains) is present at the power input of the operating device 1, wherein the processing unit 3a may repeatedly calibrate the internal timer 3b for a time interval using the calibration method as described above with respect to Figure 2. In addition or alternatively, the processing unit 3b may calibrate the internal timer 3b using the calibration method as described above with respect to Figure 2 at the time of turning on the operating device 1.

The operating device 1 shown in Figure 1 may comprise a temperature sensor (not shown in Figure 1). The temperature sensor is not limited to a specific type of temperature sensor. The temperatures sensor is configured to measure the temperature of the operating device 1, in particular, of the internal timer 3b. In particular, the temperature sensor is configured to measure the temperature in a vicinity and/or inside the operating device 1. Moreover, in particular, the temperature sensor is configured to measure the temperature in a vicinity and/or inside the control circuitry 3. In addition or alternatively, the temperature sensor is configured to measure the temperature in a vicinity and/or inside the internal timer 3b.

The processing unit 3a is configured to carry out the calibration of the internal timer 3b for different temperatures.

In particular, the processing unit 3a is configured to assign the calibration time interval T2 to the determined number of oscillations of the first clock signal for different temperatures, and save these assignments for different temperatures in the data storage 3c.

The processing unit 3a may be configured to determine time intervals on the basis of the first clock signal using the assignment of the calibration time interval T2 to the determined number of oscillations of the first clock signal (calibrated assignment), the assignment corresponding to the actual temperature of the operating device 1. The temperature sensor preferably provides the processing unit 3a with corresponding temperature data of the operating device 1.

In particular, the processing unit 3a is configured to assign the calibration time interval T2 to the determined number of oscillations of the first clock signal for different temperatures, and save these assignments for different temperatures in a lookup table of the data storage 3c.

The processing unit 3a may calibrate the internal timer 3b, in case the processing unit 3a determines a temperature change on the basis of temperature data provided by the temperature sensor.

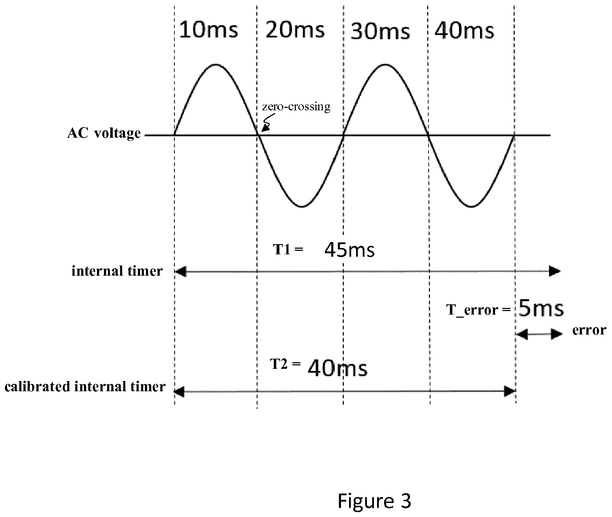

**Figure 3** is a graph exemplarily showing a calibration method according to a preferred embodiment of the invention performed by the operating device according to Figure 1. The values shown in Figure 3 are merely by way of example and the present invention is not limited by them.

On the top of Figure 3 the AC voltage provided by the external AC voltage source 7 (mains) to the power input of the operating device 1 is shown. According to Figure 3, the calibration time interval T2 equals to 40 ms. The number of zero-crossings of the AC voltage corresponding to the calibration time interval T2 determined by the processing unit 3a in step 201 of the calibration method according to Figure 2 equals five, as shown at the top of Figure 3.

According to the middle of Figure 3, the first time interval T1 determined by the processing unit 3a in step 203 of the calibration method according to Figure 2 equals 45 ms, although it should also equal interval 40 ms. Therefore, there is an error T_error of 5ms between the first time interval T1 of the internal timer 3b and the actual time interval corresponding to the calibration time interval T2.

Such a deviation between the first time interval T1 and the actual time interval corresponding to the calibration time interval T2 may be due to a temperature change that has an impact on the frequency respectively period of the oscillating signal (first clock signal) of the internal timer 3b.

Therefore, when comparing in step 204 of the calibration method according to Figure 2 the determined first time interval T1 with the calibration time interval T2, step 205 of the calibration method according to Figure 2 is triggered. As a result, the calibration time interval T2 is assigned as the first time interval to the determined number of oscillations of the first clock signal in step 205 of the calibration method according to Figure 2, as indicated at the bottom of Figure 3.

Thus, due to the calibration of the internal timer 3b the determined number of oscillations of the first clock signal corresponds to the actual time interval, namely the calibration time interval T2. The processing unit 3a therefore may measure time on the basis of the first clock signal provided by the internal timer 3b.

## Claims

1. Operating device (1) for operating one or more lighting means (8),
- the operating device (1) comprising:
- an power input (IN, IN') electrically connectable to an external AC voltage source (7), preferably mains,
- an power output (OUT, OUT') to which the one or more lighting means are electrically connectable,
- a supply circuitry (2) configured to supply via the power output (OUT, OUT') the one or more lighting means (8) with DC power from an AC voltage provided by the external AC voltage source (7) via the power input (IN, IN') to the supply circuitry (2), and
- a control circuitry (3) comprising a processing unit (3a) configured to control the supply circuitry (2) and an internal timer (3b) configured to provide to the processing unit (3a) a first clock signal;
- wherein the processing unit (3a) is configured to calibrate the internal timer (3b) on the basis of the temporal course of the AC voltage.

2. Operating device (1) according to claim 1, wherein
- the operating device (1) comprises a detection unit configured to detect zero-crossings of the AC voltage and to provide the detected zero-crossings to the processing unit (3a), and
- the processing unit (3a) is configured to calibrate the internal timer (3b) on the basis of the detected zero-crossings of the AC voltage and the frequency of the AC voltage.

3. Operating device (1) according to claim 1 or 2, wherein the operating device (1), preferably the control circuitry (3), comprises a zero-crossing timer configured to provide a second clock signal to the processing unit (3a) by detecting the zero-crossings of the AC voltage, and
- the processing unit (3a) is configured to calibrate the internal timer (3b) on the basis of the second clock signal.

4. Operating device (1) according to any one of the preceding claims, wherein
- the internal timer (3b) comprises an internal oscillator providing an oscillating signal as the first clock signal, wherein a number of oscillations of the oscillating signal is assigned to a first time interval (T1).

5. Operating device (1) according to claim 4, wherein
- the processing unit (3a) is configured to calibrate the internal timer (3b) by comparing the temporal course of the AC voltage with the temporal course of the oscillations of the first clock signal during a calibration time interval (T2).

6. Operating device (1) according to claim 5, wherein the processing unit (3a) is configured to
- determine the number of zero-crossings of the AC voltage corresponding to the calibration time interval (T2), and
- determine the number of oscillations of the first clock signal corresponding to the determined number of zero-crossings of the AC voltage.

7. Operating device (1) according to claim 6, wherein the processing unit (3a) is configured to
- determine the first time interval (T1) assigned to the determined number of oscillations of the first clock signal,
- compare the determined first time interval (T1) with the calibration time interval (T2), and
- assign the calibration time interval (T2) as the first time interval to the determined number of oscillations of the first clock signal, in case the determined first time interval (T1) does not equal to the calibration time interval (T2).

8. Operating device (1) according to claim 7, wherein
- the operating device (1) comprises a data storage (3c), which preferably is an internal data storage of the control circuitry (3),
- wherein the processing unit (3a) is configured to save the assignment between the calibration time interval (T2) and the determined number of oscillations of the first clock signal in the data storage (3c).

9. Operating device (1) according to any one of the preceding claims, wherein
- the operating device (1) comprises a temperature sensor, and
- the processing unit (3a) is configured to carry out the calibration of the internal timer (3b) for different temperatures.

10. Operating device (1) according to claim 9, wherein the processing unit (3a) is configured to
- assign the calibration time interval (T2) to the determined number of oscillations of the first clock signal for different temperatures, and
- save these assignments for different temperatures in the data storage (3c).

11. Operating device (1) according to any one of the preceding claims, wherein
- the operating device (1) comprises an AC voltage detection unit configured to detect the AC voltage at the power input (IN, IN'), and
- the processing unit (3a) is configured to calibrate the internal timer (3b) in case that the AC voltage is present at the power input (IN, IN') and preferably to repeatedly calibrate the internal timer (3b) in a time interval.

12. Operating device (1) according to any one of the preceding claims, wherein
- the control circuitry (3) is a microprocessor or microcontroller internally comprising the internal timer (3b).

13. Operating device (1) according to any one of the preceding claims, wherein
- the operating device (1) is an emergency lighting operating device comprising a preferably rechargeable energy storage, such as a preferably rechargeable battery,
- the control circuitry (3) is electrically supplied with DC power from the energy storage, and
- the supply circuitry (2) is configured to supply via the power output (OUT, OUT') the one or more lighting means (8) with DC power from the energy storage.

14. Luminaire (9), comprising
- an operating device (1) according to any one of the preceding claims, and
- one or more lighting means (8) electrically connected to the power output (OUT, OUT') of the operating device (1),
- wherein the operating device (1) is configured to operate the one or more lighting means by supplying the one or more lighting means (8) with DC power.

15. Method of calibrating the internal timer (3b) of the control circuitry (3) of an operating device (1) according to any one of the claims 1 to 13, comprising the step of
- calibrating by the processing unit (3a) the internal timer (3b) on the basis of the temporal course of the AC voltage.
